# EUROPÄISCHE PATENTANMELDUNG

(11) **EP 3 399 546 A1**
(43) Veröffentlichungstag der Anmeldung: **07.11.2018**
(21) Anmeldenummer: 17169007.6
(22) Anmeldetag: 02.05.2017
(51) Int. Cl.: H01L 23/15, H01L 23/367

(54) **ELEKTRONISCHE BAUGRUPPE MIT EINEM ZWISCHEN ZWEI SUBSTRATEN EINGEBAUTEN BAUELEMENT UND VERFAHREN ZU DESSEN HERSTELLUNG**

(71) Anmelder: Siemens Aktiengesellschaft, 80333 München (DE)
(72) Erfinder: Knofe, Rüdiger, 14513 Teltow (DE); Müller, Bernd, 16259 Falkenberg (DE); Strogies, Jörg, 14163 Berlin (DE); Wilke, Klaus, 12527 Berlin (DE); Blank, Rene, 12249 Berlin (DE); Franke, Martin, 14089 Berlin (DE); Frühauf, Peter, 14612 Falkensee (DE); Nerreter, Stefan, 15754 Heidesee OT Blossin (DE)

(57) **Zusammenfassung**

Die Erfindung betrifft eine elektronische Baugruppe mit einem Bauelement (11), welches zwischen einem ersten Substrat (12) und einem zweiten Substrat (13) gehalten ist. Erfindungsgemäß ist vorgesehen, dass ein Spalt (18) zwischen dem ersten Substrat (12) und dem Bauelement (11) mit einem Durchgangsloch (21) verbunden ist, so dass durch das Durchgangsloch hindurch beispielsweise ein Lotwerkstoff (24) unter Ausnutzung von im Durchgangsloch (21) und im Spalt (18) wirkenden Kapillarkräften dosiert werden kann. Dabei erfolgt die Dosierung automatisch, da die Kapillarkräfte nur im Spalt wirken. Vorteilhaft lässt sich durch die automatische Dosierung des Lotwerkstoffs ein Toleranzausgleich bewerkstelligen, der aufgrund unterschiedlicher Spaltmaße notwendig werden kann. Die Erfindung betrifft auch ein Verfahren zum Herstellen der beschriebenen Baugruppe, wobei der Fügehilfsstoff (24) insbesondere als Lotwerkstoff durch Selektivwellenlöten appliziert werden kann.

## Beschreibung

Die Erfindung betrifft eine elektronische Baugruppe mit einem Bauelement, welches zwischen einem ersten Substrat und einem zweiten Substrat eingebaut ist. Dabei steht das Bauelement mit dem ersten Substrat und dem zweiten Substrat in Kontakt. Hierbei kann es sich um eine elektrische Kontaktierung oder einer anderweitigen Kontaktierung, z. B. eine thermisch leitende Kontaktierung, handeln. Außerdem ist zwischen dem ersten Substrat und dem Bauelement ein Spalt vorgesehen, der mit einem Fügehilfsstoff ausgeführt ist. Bei dem Fügehilfsstoff kann es sich beispielsweise um einen Kleber, evtl. um einen elektrisch leitfähigen Kleber, oder insbesondere um einen Lotwerkstoff handeln.

Weiterhin betrifft die Erfindung ein Verfahren zum Erzeugen einer elektrischen Baugruppe, bei dem ein Bauelement, insbesondere ein elektronisches Bauelement, zwischen einem ersten Substrat und einem zweiten Substrat montiert wird. Dabei wird das Bauelement einerseits auf dem zweiten Substrat kontaktiert und andererseits auch auf dem ersten Substrat kontaktiert, indem ein sich zwischen dem ersten Substrat und dem Bauelement befindender Spalt mit einem Fügehilfsstoff überbrückt wird.

Solche Baugruppen der eingangs angegebenen Art mit einem zwischen zwei Substraten gehaltenen elektronischen Bauelement in Form eines Leistungshableiters sind beispielsweise gemäß der DE 10 2014 206 601 A1 und DE 10 2014 206 606 A1 beschrieben.

Bei der beidseitigen Kontaktierung von Bauelementen wie z. B. leistungselektronischen Chips (auch bare dies genannt) in Kavitäten, die durch zwei Substrate, wie z. B. Schaltungsträger gebildet werden, muss die Einbauhöhe der Kavität auf die Dicke der Bauelemente angepasst werden. Hierbei entsteht eine Toleranzkette, insbesondere, wenn mehrere Bauelemente zwischen den Substraten angeordnet werden oder die Substrate selbst direkt miteinander verbunden werden. Soll die Kavität in eines der Substrate, beispielsweise in eine Leiterplatte, aus einem Glasfaser-Harz-Verbundwerkstoff eingebracht werden, so treten bereits beim Herstellen dieser Kavität Toleranzen auf. Außerdem sind auch die Bauelemente toleranzbedingt unterschiedlich hoch. Bei der Verarbeitung der genannten Bauteile können daher Toleranzen von mehr als 100 µm auftreten. Diese Toleranzen sind mit dem Ausgleichsvermögen von gebräuchlichen Sinter- oder Lötverbindungen nicht ohne Weiteres auszugleichen. Deswegen kann es beispielsweise passieren, dass ein Lotwerkstoff bei einem zu kleinen Spalt seitlich aus der Lötverbindung herausquillt oder bei einem zu großen Spalt nicht genügend Lotwerkstoff im Spalt vorhanden ist. Beides beeinträchtigt die thermische und elektrische Leitfähigkeit der ausgebildeten Verbindung.

Um dem entgegenzuwirken, kann die Tiefe jeder Kavität und die Höhe jedes Bauelements vermessen werden, um einen Lotauftrag individuell auf die vorliegenden Toleranzen anzupassen. Bei diesem Verfahren würden aber zwei zusätzliche Prozessschritte, nämlich die Vermessung und die individuelle Lotdosierung, anfallen, was einen zusätzlichen Fertigungsaufwand bedeuten würde.

Eine andere Möglichkeit liegt darin, einen konstruktiven Toleranzausgleich vorzusehen. Gemäß der DE 10 2014 206 608 A1 kann beispielsweise vorgesehen werden, dass als Substrat eine Haube vorgesehen wird, die aus einem thermisch erweichbaren oder thermisch aushärtbaren Material, also aus einem Harz oder einem thermoplastischen Kunststoff, besteht. Die Haube kann dann beim Fügen der Verbindungen zu dem Bauelement bzw. dem anderen Substrat soweit erwärmt werden, dass diese sich plastisch verformen lässt und auf diese Weise Toleranzen beim Fügen ausgleicht. Allerdings ist der Aufbau dieser Haube vergleichsweise komplex, wenn auf dieser elektrische Schaltungen realisiert werden sollen.

Die Aufgabe der Erfindung besteht daher darin, eine elektronische Baugruppe mit einem zwischen zwei Substraten eingebauten Bauelement anzugeben, welche einfach montiert werden kann und bei der auftretende Fertigungs- und Montagetoleranzen zuverlässig ausgeglichen werden können. Außerdem besteht die Aufgabe der Erfindung darin, für eine solche elektronische Baugruppe ein Montageverfahren anzugeben.

Diese Aufgabe wird mit der eingangs angegebenen elektronischen Baugruppe erfindungsgemäß dadurch gelöst, dass das erste Substrat ein Durchgangsloch aufweist, welches in den Spalt zwischen dem Bauelement und dem ersten Substrat mündet und welches durch den Fügehilfsstoff verschlossen ist. Dabei kann das Loch auch mit dem Fügehilfsstoff ganz oder teilweise ausgefüllt sein. Zumindest muss der Fügehilfsstoff aber den Spalt ausfüllen. Das Loch dient dabei der Dosierung des Fügehilfsstoffs von außen in den Spalt. Dies hat den Vorteil, dass die elektronische Baugruppe vormontiert werden kann, wobei das Bauelement mit dem zweiten Substrat kontaktiert wird und dadurch in seiner Position fixiert wird. Dabei ergibt sich der Spalt mit einem toleranzbehafteten Spaltmaß, welches durch die Summe aller auftretenden Toleranzen beeinflusst wird. Toleranzen können vorrangig bei der Höhe einer sich ausbildenden Kavität zwischen dem ersten Substrat und dem zweiten Substrat, der Höhe des Bauelements und bei den Verbindungsstellen zwischen dem Bauelement und dem zweiten Schaltungsträger sowie evtl. bei einer Verbindung zwischen dem ersten und dem zweiten Substrat entstehen. Diese Toleranzen können nun durch die Dosierung der richtigen Menge an Fügehilfsstoff durch das Durchgangsloch von außen ausgeglichen werden.

Hierbei kommt ein Verfahren zum Erzeugen der elektronischen Baugruppe zum Einsatz, welches die oben angegebene Aufgabe löst. Bei diesem Verfahren wird der Fügehilfsstoff durch das Durchgangsloch in den Spalt eingefüllt, wobei genauso viel des Fügehilfsstoffs dosiert wird, dass sich die gewünschte Verbindung zwischen dem Bauelement und dem Substrat ausbildet. Dabei ist es besonders vorteilhaft, wenn der Fügehilfsstoff unter Ausnutzung des Kapillareffekts in dem Spalt dosiert wird. Die zu dosierende Menge ergibt sich dadurch automatisch, weil der Fügehilfsstoff aufgrund der Kapillarkräfte nicht aus dem Spalt und dem Durchgangsloch austreten kann. Der Fügehilfsstoff wird dann verfestigt. Handelt es sich beispielsweise um einen Leitkleber, so härtet dieser aus. Handelt es sich um einen Lotwerkstoff, so erstarrt dieser in dem Spalt.

Gemäß einer vorteilhaften Ausgestaltung des Verfahrens kann das Dosieren des Fügehilfsstoffs durch Dispensen erfolgen. Dabei wird der Fügehilfsstoff mit einer geeigneten Dosiervorrichtung in das Durchgangsloch eingebracht und durch den Kapillareffekt in den Spalt gesogen. Gemäß einer anderen Ausgestaltung der Erfindung kann das Dosieren durch Selektivwellenlöten erfolgen. Bei diesem Verfahren wird die Selektivlötwelle aus geschmolzenem Lotwerkstoff an das Durchgangsloch angenähert und der Lotwerkstoff durch das Durchgangsloch in den Spalt gesogen. Anschließend kann das Durchgangsloch vorteilhaft außen mit einem elektrischen Isolierstoff verschlossen werden, um eine elektrische Isolation nach außen zu gewährleisten.

Soll der Spalt mit einem Lotwerkstoff ausgefüllt werden, so sieht eine Ausgestaltung der Erfindung vor, dass die Wände des Durchgangslochs mit einer Metallschicht beschichtet sind. Diese Metallschicht ist durch den Lotwerkstoff leicht benetzbar, so dass dieser aufgrund der Kapillarkräfte leicht in das Durchgangsloch gesogen werden kann. Die Metallschicht kann beispielsweise wie eine Durchkontaktierung von Leiterplatten gestaltet sein. Selbstverständlich ist auch der Spalt metallisiert, was einerseits durch eine Metallisierung des Bauelements und andererseits durch eine Metallisierung des Substrats im Bereich des Spalts realisiert ist. Auf diese Weise kann der Spalt zur Ausbildung einer elektrisch leitfähigen Verbindung zwischen dem Bauelement und dem Substrat dienen, wobei auf dem ersten Substrat eine Schaltungsanordnung zur elektrischen Verschaltung des Bauelements realisiert sein kann.

Gemäß einer besonders vorteilhaften Ausgestaltung der Erfindung ist die Metallschicht auf eine dem Spalt gegenüberliegende Außenseite des ersten Substrats um den Rand des Durchgangsloches herum herausgeführt. Dies kann beispielsweise dadurch realisiert sein, dass um den Rand des Durchgangslochs eine ringförmige Metallisierung auf der Außenseite ausgebildet ist. Diese steht in Kontakt mit der Metallschicht im Durchgangsloch. Dies unterstützt die Dosierung von Lotwerkstoff in den Spalt und das Durchgangsloch, wenn z. B. die Außenseite des ersten Substrats mit einer Selektivlötwelle in Kontakt gebracht wird.

Gemäß einer weiteren Ausgestaltung der Erfindung ist vorgesehen, dass erste Substrat oder das zweite Substrat aus einer Keramik besteht. Diese kann metallisch beschichtet sein, zum Beispiel mit Silber oder Kupfer. Diese kann außerdem als Schaltungsträger ausgeführt sein, auf der eine leistungselektronische Schaltung realisiert ist. Die Keramik ermöglicht dabei eine vergleichsweise gute Wärmeabführung. Weiterhin kann vorgesehen werden, dass das erste Substrat oder das zweite Substrat aus einer Leiterplatte besteht. Diese kann vorteilhaft dazu dienen, um eine Aussparung zur Bildung einer Kavität für das Bauelement zu erzeugen. Die Kavität lässt sich in dem Leiterplattenmaterial, welches vorzugsweise aus einem faserverstärkten Harz besteht, mit vertretbarem Fertigungsaufwand herstellen. Als Leiterplattenmaterial kann zum Beispiel ein sogenanntes FR4-Material zum Einsatz kommen Hierbei handelt es sich um ein mit Glasfaseren verstärken Kunststoff auf Basis von Epoxidharz, welches schwer entflammbar ist. Das Material ist typischerweise mit Kupfer beschichtet, bevorzugt mit einem Finish aus einer Nickel-Gold-Legierung, Zinn oder Silber.

Weiterhin kann vorteilhaft vorgesehen werden, dass das erste Substrat oder das zweite Substrat aus einem Kühlkörper besteht. Ein Kühlkörper wird üblicherweise thermisch gut leitfähig an das Bauelement angeschlossen. Dies kann insbesondere auch durch Applikation eines Fügehilfstoffe geschehen.

Für das erste Substrat und das zweite Substrat gibt es besonders vorteilhafte Paarungen. Beispielsweise kann das erste Substrat eine Leiterplatte sein und das zweite Substrat aus einer Keramik bestehen. Eine andere Möglichkeit besteht darin, dass das erste Substrat eine Leiterplatte und das zweite Substrat ein Kühlkörper ist oder andersherum das zweite Substrat eine Leiterplatte und das erste Substrat ein Kühlkörper ist.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben. Es zeigen:
- Figur 1 und 2: Ausführungsbeispiele der erfindungsgemäßen Baugruppe jeweils geschnitten und
- Figur 3 und 4: Ausführungsbeispiele des erfindungsgemäßen Verfahrens jeweils in einem repräsentativen Fertigungsschritt geschnitten.

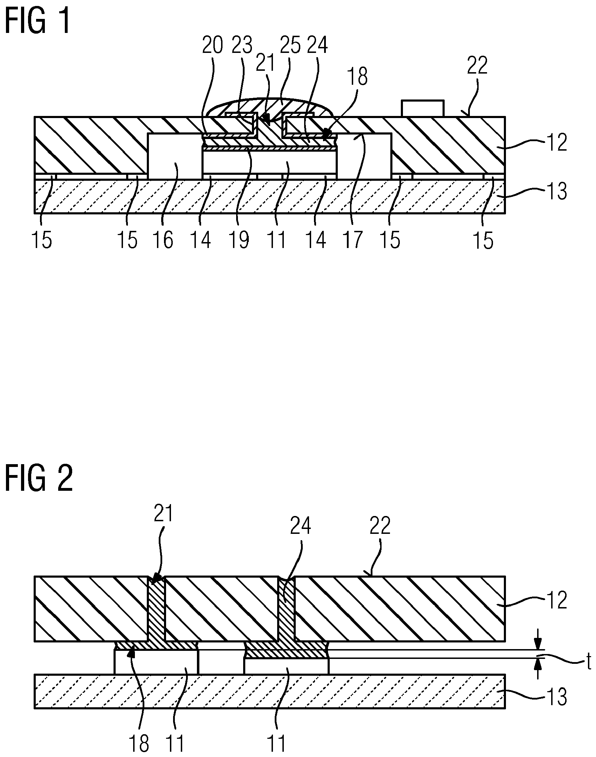

In Figur 1 ist eine elektronische Baugruppe dargestellt, bei der ein Bauelement 11 in Form eines Halbleiterchips zwischen einem ersten Substrat 12 in Form einer Leiterplatte und einem zweiten Substrat 13 in Form eines keramischen Schaltungsträgers gehalten ist. Auf dem zweiten Substrat 13 ist das Bauelement 11 mittels Sinterverbindungen 14 elektrisch kontaktiert. Außerdem sind das erste Substrat 12 und das zweite Substrat 13 über Lötverbindungen 15 direkt miteinander elektrisch kontaktiert.

Zwischen dem ersten Substrat 12 und dem zweiten Substrat 13 ist eine Kavität 16 ausgebildet, die aus einer Vertiefung im ersten Substrat besteht. In dieser Kavität 16 befindet sich auch das elektronische Bauelement 11. Allerdings ergibt sich zwischen dem elektronischen Bauelement 11 und einem Boden 17 der die Kavität 16 bildenden Vertiefung ein Spalt 18, wobei dieser durch eine Metallisierung 19 des Bauelements 11 und eine Metallisierung 20 des Bodens 17 ausgekleidet ist. Außerdem mündet in den Spalt 18 eine Durchgangsloch 21, welches eine Außenseite 22 des ersten Substrats 12 mit dem Spalt 18 verbindet. Dieses Durchgangsloch 21 ist mit einer Metallschicht 23 ausgekleidet, die sich am Rand des Durchgangslochs 21 auch auf die Außenseite 22 des ersten Substrats 12 erstreckt. Diese Metallschicht 23 ist als Durchkontaktierung im ersten Substrat 12 hergestellt worden.

Der Spalt 18 sowie das Durchgangsloch 21 sind mit dem Fügehilfsstoff 24 ausgefüllt, wobei es sich hierbei um ein Lot oder um einen Leitkleber handeln kann. Typische Lotwerkstoffe sind SnAgCu-Legierungen, sogenannte SAC-Lote. Alternativ können Bleilote zum Einsatz kommen, zum Beispiel SnPb- oder SnPbAg- Legierungen. Außerdem ist das Durchgangsloch 21 optional auf der Außenseite 22 mit einem elektrischen Isolierstoff 25 verschlossen, um eine elektrische Isolation zu gewährleisten. Dies kann zum Beispiel mit einer Silikonmasse oder einem Epoxidharzkleber erfolgen.

Gemäß Figur 2 kommen als erstes Substrat 12 ein Kühlkörper und als zweites Substrat 13 ein Schaltungsträger zum Einsatz, wobei der Schaltungsträger als Leiterplatte oder als Keramiksubstrat ausgebildet sein kann. Auf dem zweiten Substrat sind mehrere elektronische Bauelemente 11 vorgesehen, die aufgrund von Toleranzen t unterschiedlich hoch sind. Hierbei handelt es sich um Leistungshalbleiter. Um diese zu kühlen, ist das erste Substrat in Form eines Kühlkörpers vorgesehen, wobei dieses über den Fügehilfsstoff 24 mit den Bauelementen 11 verbunden ist (optional kommt auch der Isolierstoff 25 zum Einsatz). In Figur 2 ist dargestellt, wie die aufgrund der Toleranz t unterschiedlich hoch ausgebildeten Spalte 18 gleichmäßig mit dem Fügehilfsstoff ausgefüllt sind. Dieser besteht vorzugsweise aus Lot, da das Lot ein guter Wärmeleiter ist.

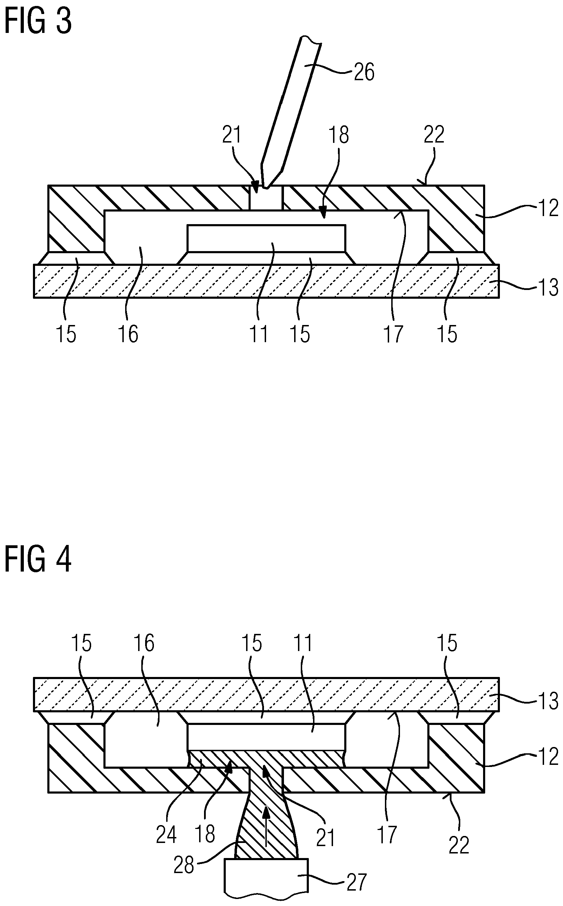

Der Figur 3 lässt sich ein mögliches Fertigungsverfahren für die elektronische Baugruppe entnehmen. In einem ersten Schritt können das Bauelement 11, das erste Substrat 12 und das zweite Substrat 13 in der in Figur 3 dargestellten Lage zusammengesetzt werden. Die so zusammengesetzte Baugruppe kann dann in nicht näher dargestellter Weise einen Reflow-Lötofen durchlaufen, wobei die Lötverbindungen 15 als Diffusionslötverbindungen ausgebildet werden. Nach dem Erkalten kann mittels einer Dosiervorrichtung 26 der Fügehilfsstoff in den Spalt 18 dispenst werden. Die erforderliche Menge des Fügehilfsstoffs stellt sich aufgrund des in dem Spalt 18 wirkenden Kapillareffekts automatisch ein.

Die Baugruppe gemäß Figur 4 kann wie zu Figur 3 beschrieben durch Reflow-Löten vormontiert werden. Anschließend wird die Baugruppe gewendet, so dass diese mit der Außenseite nach unten ausgerichtet ist. An das Durchgangsloch 21 wird dann ein Selektivlötkopf 27 derart angenähert, dass eine Selektivlötwelle 28 die in Figur 4 aus Gründen der Übersichtlichkeit nicht näher dargestellte Metallschicht 23 (vgl. Figur 1) erreicht. Aufgrund der im Durchgangsloch 21 und im Spalt 18 wirkenden Kapillarkräfte und der guten Benetzbarkeit der Metallschicht wird das flüssige Lot in den Spalt gesogen und kann dann dort erstarren.

## Patentansprüche

1. Elektronische Baugruppe mit einem Bauelement (11), welches zwischen einem ersten Substrat (12) und einem zweiten Substrat (13) eingebaut ist, wobei
• das Bauelement mit dem ersten Substrat (12) und dem zweiten Substrat (13) in Kontakt steht und
• zwischen dem ersten Substrat (12) und dem Bauelement ein Spalt (18) vorgesehen ist, der mit einem Fügehilfsstoff (24) überbrückt ist,
**dadurch gekennzeichnet,**
**dass** das erste Substrat (12) ein Durchgangsloch (21) aufweist, welches in den Spalt (18) mündet und durch den Fügehilfsstoff (24) verschlossen ist.

2. Baugruppe nach Anspruch 1,
**dadurch gekennzeichnet,**
**dass** das erste Substrat (13) und das zweite Substrat (18) eine gegen die Umgebung geschlossene Kavität (16) ausbilden.

3. Baugruppe nach einem der voranstehenden Ansprüche, **dadurch gekennzeichnet,**
**dass** das erste Substrat (12) oder der zweite Substrat (13) aus einer Keramik besteht.

4. Baugruppe nach einem der voranstehenden Ansprüche, **dadurch gekennzeichnet,**
**dass** das erste Substrat (12) oder das zweite Substrat (13) aus einer Leiterplatte besteht.

5. Baugruppe nach einem der voranstehenden Ansprüche, **dadurch gekennzeichnet,**
**dass** das erste Substrat (12) oder das zweite Substrat (13) aus einem Kühlkörper besteht.

6. Baugruppe nach einem der voranstehenden Ansprüche, **dadurch gekennzeichnet,**
**dass** das Bauelement (11) ein Halbleiterchip ist.

7. Baugruppe nach einem der voranstehenden Ansprüche, **dadurch gekennzeichnet,**
**dass** die Wände des Durchgangsloches (21) mit einer Metallschicht (23) beschichtet sind.

8. Baugruppe nach Anspruch 7,
**dadurch gekennzeichnet,**
**dass** die Metallschicht (23) auf eine dem Spalt (18) gegenüberliegende Außenseite (22) des ersten Substrats (12) um den Rand des Durchgangsloches herum herausgeführt ist.

9. Baugruppe nach einem der voranstehenden Ansprüche, **dadurch gekennzeichnet,**
**dass** das Durchgangsloch (21) außen mit einem elektrischen Isolierstoff (25) verschlossen ist.

10. Verfahren zum Erzeugen einer elektronischen Baugruppe, bei dem ein Bauelement (11) zwischen einem ersten Substrat (12) und einem zweiten Substrat (13) montiert wird, wobei
• das Bauelement auf dem zweiten Substrat (13) kontaktiert wird und
• ein sich zwischen dem ersten Substrat (12) und dem Bauelement befindender Spalt (18) mit einem Fügehilfsstoff (24) überbrückt wird,
**dadurch gekennzeichnet,**
**dass** das erste Substrat (12) ein Durchgangsloch (21) aufweist, welches in den Spalt (18) mündet und durch das der Fügehilfsstoff (24) in den Spalt (18) eingefüllt wird.

11. Verfahren nach Anspruch 10,
**dadurch gekennzeichnet,**
**dass** der Fügehilfsstoff (24) unter Ausnutzung des Kapillareffektes in dem Spalt dosiert wird.

12. Verfahren nach Anspruch 11,
**dadurch gekennzeichnet,**
**dass** das Dosieren durch Dispensen erfolgt

13. Verfahren nach Anspruch 11,
**dadurch gekennzeichnet,**
**dass** das Dosieren durch Selektivwellenlöten erfolgt.

14. Verfahren nach einem der Ansprüche10 bis 13,
**dadurch gekennzeichnet,**
**dass** das Durchgangsloch (21) nach dem Ausfüllen des Spaltes (18) mit dem Fügehilfsstoff (24) außen mit einem elektrischen Isolierstoff (25) verschlossen wird.
